# EUROPEAN PATENT APPLICATION

(11) **EP 4 012 760 A1**
(43) Date of publication of application: **15.06.2022**
(21) Application number: 20851554.4
(22) Date of filing: 07.08.2020
(51) Int. Cl.: H01L 23/02, H01S 5/022

(54) **PACKAGE FOR MOUNTING OPTICAL ELEMENT, ELECTRONIC DEVICE, AND ELECTRONIC MODULE**

(30) Priority: 09.08.2019 JP 2019147778
(71) Applicant: Kyocera Corporation, Kyoto-shi Kyoto 612-8501 (JP)
(72) Inventor: KITAGAWA, Akihiko, Kyoto-shi, Kyoto 612-8501 (JP); KIMURA, Takashi, Kyoto-shi, Kyoto 612-8501 (JP)
(74) Representative: Viering, Jentschura & Partner mbB Patent- und Rechtsanwälte
(86) International application number: PCT/JP2020/030410
(87) International publication number: WO 2021/029371

(57) **Abstract**

An optical-element mounting package includes: a metal base (2B); an insulating base (2A) having a frame shape and located on the metal base; an external terminal (D1, D2) located on the insulating base; a wiring (V1, V2, L1, L2) located in the insulating base and electrically connected to the external terminal; and a reflecting component (8). A cavity (3) enclosed by the metal base and the inner wall of the insulating base includes a first region (301) and a second region (302). The first region includes a first mounting portion for an optical element (11). The second region includes a second mounting portion for the reflecting component. The first region and the second region are arranged in a direction in which light from the optical element travels toward the reflecting component. The wiring is located toward the first region relative to the second region.

## Description

### Technical Field

The present invention relates to an optical-element mounting package, an electronic device, and an electronic module.

### Background Art

Transistor Outline (TO)-Can semiconductor lasers incorporating a laser chip are known in the art (Japanese Unexamined Patent Application Publication No. 2004-031900).

### Summary of Invention

An optical-element mounting package according to the present disclosure includes:
a metal base;
an insulating base having a frame shape and located on the metal base;
an external terminal located on the insulating base;
a wiring located in the insulating base and electrically connected to the external terminal; and
a reflecting component.

A cavity enclosed by the metal base and an inner wall of the insulating base includes a first region and a second region.

The first region includes a first mounting portion for an optical element.

The second region includes a second mounting portion for the reflecting component.

The first region and the second region are arranged in a direction in which light from the optical element travels toward the reflecting component.

The wiring is located toward the first region relative to the second region.

An electronic device according to the present disclosure includes the optical-element mounting package mentioned above, and an optical element mounted over the first mounting portion.

An electronic module according to the present disclosure includes the electronic device mentioned above, and a module substrate over which the electronic device is mounted.

### Brief Description of Drawings

[Fig. 1] Fig. 1 is a plan view of an electronic device according to an embodiment of the present disclosure.
[Fig. 2] Fig. 2 is a sectional view, taken along a line A-A, of the electronic device illustrated in Fig. 1.
[Fig. 3] Fig. 3 is a sectional view of the electronic device illustrated in Fig. 1, including an optical axis of the electronic device.
[Fig. 4] Fig. 4 is a plan view of an electronic device according to a modification of the electronic device illustrated in Fig. 1.
[Fig. 5] Fig. 5 is a sectional view of the electronic device illustrated in Fig. 4, including an optical axis of the electronic device.
[Fig. 6] Fig. 6 is a sectional view of an electronic device according to a modification of the electronic device illustrated in Fig. 1, including an optical axis of the electronic device.
[Fig. 7] Fig. 7 is a sectional view of an electronic device according to a modification of the electronic device illustrated in Fig. 4, including an optical axis of the electronic device.
[Fig. 8] Fig. 8 is a longitudinal sectional view of an exemplary electronic module according to the present disclosure.
[Fig. 9] Fig. 9 is a longitudinal sectional view of another exemplary electronic module according to the present disclosure.

### Description of Embodiments

Embodiments of the present disclosure are described in detail below with reference to the drawings.

### (Embodiment 1)

In the following description, "upper" or "top" refers to a direction toward a first surface Su of a base 2, and "lower" or "bottom" refers to a direction toward a second surface Sb. Directional terms such as upper, top, bottom, or lower as used herein may not necessarily coincide with the upper, top, bottom, or lower side during actual use of an electronic device 10. In the drawings, the Z-axis is depicted as the direction of thickness (top-bottom direction) of an optical-element mounting package, and the X-axis and the Y-axis are depicted as coordinate axes that are perpendicular to the Z-axis and orthogonal to each other. The X-axis coincides with the direction of the optical axis of an optical element 11.

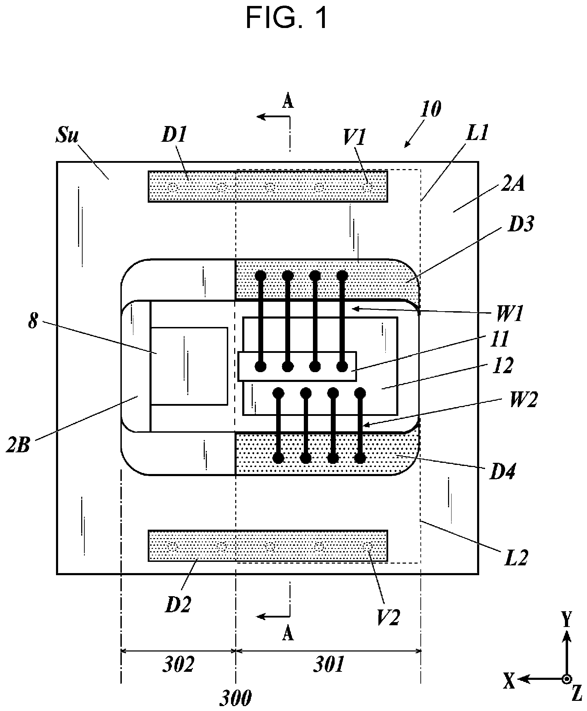

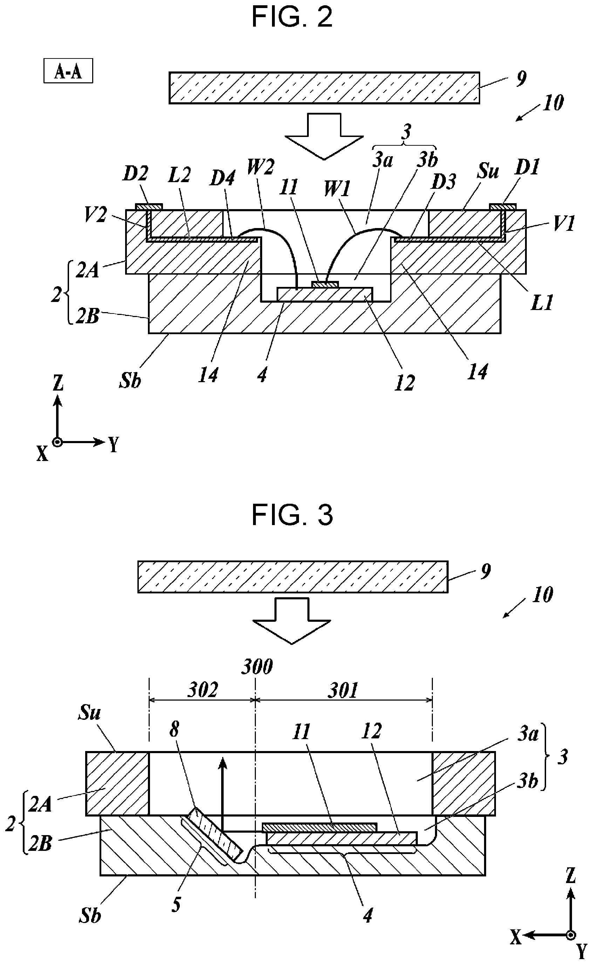

The electronic device 10 according to Embodiment 1 includes: the base 2 having the first surface Su, the second surface Sb, and a cavity 3 defined in the first surface Su; the optical element 11 and a reflecting component 8, which are to be mounted within the cavity 3; and a lid 9 that closes the top opening of the cavity 3. The lid 9 is made of a material that transmits light (glass or resin). The lid 9 is joined to the first surface Su of the base 2 by use of a joining material. It is to be noted that Fig. 1 does not illustrate the lid 9, and Figs. 2 and 3 illustrate the lid 9 as being separated from the main body. A portion of the electronic device 10 excluding the lid 9, the optical element 11, and a sub-mount 12 corresponds to an optical-element mounting package.

The base 2 includes an insulating base 2A and a metal base 2B. The insulating base 2A is located on the metal base 2B. The insulating base 2A is in the shape of a frame with a through-hole 3a that extends through the insulating base 2A in the Z-direction. The metal base 2B includes a recess 3b that communicates with the through-hole 3a. The insulating base 2A and the metal base 2B are to be joined together. Upon joining the insulating base 2A and the metal base 2B together, the recess 3b and the through-hole 3a communicate with each other to define the cavity 3 that opens upward. In other words, the cavity 3 includes the recess 3b defined in the metal base 2B.

The insulating base 2A is made of, for example, a ceramic material such as a sintered aluminum oxide compact (alumina ceramic), a sintered aluminum nitride compact, a sintered mullite compact, or a sintered glass-ceramic compact. The insulating base 2A can be fabricated by, for example, shaping a ceramic green sheet, which is a ceramic material that has not been sintered yet, into a predetermined shape by blanking, die cutting, or other methods, and sintering the resulting ceramic green sheet. The insulating base 2A further includes: external terminals D1 and D2 disposed on the first surface Su; and a wiring (V1, V2, L1, L2) electrically connected to each of the external terminals D1 and D2 to supply electricity from each of the external terminals D1 and D2 to the optical element 11. The wiring includes vias V1 and V2 and wiring conductor layers L1 and L2. Each of the wiring conductor layers L1 and L2 has a portion located within the insulating base 2A and a portion exposed into the cavity 3. The respective portions of the wiring conductor layers L1 and L2 that are exposed into the cavity 3 serve as internal connection pads D3 and D4. Each of the internal connection pads D3 and D4 is supported on the upper surface of a stepped portion 14 provided inside the insulating base 2A. The internal connection pads D3 and D4 are used as wire bonding pads. As described above, the wiring (V1, V2, L1, L2) provided in the insulating base 2A is positioned to extend continuously through the interior of the insulating base 2A into the cavity 3 from an outer surface (Su) of the insulating base 2A on which each of the external terminals D1 and D2 is to be disposed.

The wiring (V1, V2, L1, L2) provided in the insulating base 2A can be formed by coating or filling a predetermined portion of a ceramic green sheet with a conductor paste prior to sintering and then sintering the conductor paste together with the ceramic green sheet.

The metal base 2B is made of, for example, a metallic material with high thermal conductivity, such as copper or aluminum. The metal base 2B can be formed by, for example, press forming or other methods. The recess 3b of the metal base 2B includes a first mounting portion 4 where the optical element 11 is to be mounted via the sub-mount 12 and a second mounting portion 5 where the reflecting component 8 is to be mounted. The first mounting portion 4 defines, for example, a planar surface that extends horizontally. The term "planar" conceptually includes strictly planar surfaces as well as surfaces that can be regarded as planar if minute irregularities are ignored. The second mounting portion 5 defines a planar surface inclined with respect to the horizontal direction. The second mounting portion 5 is inclined such that the second mounting portion 5 increases in elevation with increasing distance from the first mounting portion 4.

The optical element 11 is, for example, a laser diode (semiconductor laser). The optical element 11 may be any light-emitting element having directivity. The optical element 11 is joined to the upper surface of the sub-mount 12 by use of a joining material, and the sub-mount 12 is joined to the upper surface of the first mounting portion 4 by use of a joining material. The direction in which light is emitted by the optical element 11 (X-direction) coincides with a direction along the upper surface of the first mounting portion 4 or the upper surface of the sub-mount 12 (e.g., horizontal direction) and points toward the second mounting portion 5. The optical element 11 is electrically connected to the internal connection pads D3 and D4 via a wiring conductor provided in the sub-mount 12 and via bonding wires W1 and W2, respectively. The internal connection pads D3 and D4, which are located inside the cavity 3, are respectively electrically connected to the external terminals D1 and D2, which are located outside the cavity 3, via the wiring conductor (L1, L2, V1, V2). The optical element 11 is driven when electric power is input via the external terminals D1 and D2.

The reflecting component 8 is a flat mirror. The reflecting component 8 reflects incoming light from the optical element 11 upward. The reflected light is directed to exit the electronic device 10 upward via the lid 9.

As illustrated in Figs. 1 and 3, the cavity 3, which is enclosed by the metal base 2B and the inner wall of the insulating base 2A, includes a first region 301 and a second region 302. The first region 301 includes the first mounting portion 4 for the optical element 11. The second region 302 includes the second mounting portion 5 for the reflecting component 8. The first region 301 and the second region 302 are arranged in the X-direction in which light from the optical element 11 travels toward the reflecting component 8. The wiring (V1, V2, L1, L2) provided in the insulating base 2A is located toward the first region 301 relative to the second region 302.

The following describes Embodiment 1 in further detail.

With the cavity 3 viewed in plan as illustrated in Fig. 1, an imaginary boundary line 300 is drawn that runs parallel to the Y-axis and divides the first mounting portion 4 and the second mounting portion 5 from each other. A region including the first mounting portion 4 is defined as the first region 301, and a region including the second mounting portion 5 is defined as the second region 302.

As for the wiring (V1, V2, L1, L2) provided in the insulating base 2A, a portion of the wiring located inside the cavity 3 serves as the internal connection pads D3 and D4.

The internal connection pads D3 and D4 are located in the first region 301. The sub-mount 12 and the bonding wires W1 and W2 are also located in the first region 301.

The wiring extending from the optical element 11 to the external terminals D1 and D2 is not located in the second region 302.

Among major thermal conduction paths for heat generated from the optical element 11 to the metal base 2B, a first path is a path along which heat is conducted from the optical element 11 to the sub-mount 12 and then to the metal base 2B. A second path is a path along which heat is conducted from the optical element 11 to the bonding wire W1 and then to the internal connection pad D3 and, after being conducted to the internal connection pad D3, the heat spreads across the entire wiring conductor layer L1 while being conducted to the metal base 2B via the insulation located under the wiring conductor layer L1. A third path is a path along which heat is conducted from the optical element 11 to the sub-mount 12, the bonding wire W2, and then to the internal connection pad D4 and, after being conducted to the internal connection pad D4, the heat spreads across the entire wiring conductor layer L2 while being conducted to the metal base 2B via the insulation located under the wiring conductor layer L1. The entirety of each of the wiring conductor layers L1 and L2 is similarly located toward the first region 301 relative to the imaginary boundary line 300.

This helps to reduce conduction of heat generated in the optical element 11 toward the reflecting component 8, which consequently reduces potential deformation of the reflecting component 8 caused by heat. This leads to stable optical characteristics.

According to Embodiment 1, the internal connection pads D3 and D4 are located in a direction (Y-direction) perpendicular to the direction of arrangement of the first region 301 and the second region 302 (X-direction) and passing through the first mounting portion 4. In other words, the internal connection pad D3 is adjacent to the first mounting portion 4 in the Y-direction. Likewise, the internal connection pad D4 is adjacent to the first mounting portion 4 in the Y-direction.

This allows the internal connection pads D3 and D4 to be increased in length in the X-direction. Furthermore, the bonding wires W1 and W2 extend in the Y-direction. It is therefore easy to increase the number of bonding wires W1 that can be arranged side by side as illustrated in Fig. 1. Further, it is easy to increase the number of bonding wires W2 that can be arranged side by side.

The ability to increase the number of bonding wires W1 and W2 that can be arranged side by side allows for reduced electrical resistance at the location of the bonding wires W1 and W2 and improved thermal conductivity. This makes it possible to increase the amount of thermal conduction along the second and third paths, resulting in improved thermal conduction to the metal base 2B.

This helps to reduce conduction of heat generated in the optical element 11 toward the reflecting component 8, which consequently reduces potential deformation of the reflecting component 8 caused by heat. This leads to stable optical characteristics.

According to Embodiment 1, the cavity 3 has a rectangular shape in plan view as illustrated in Fig. 1. The long side of the cavity 3 extends in the X-direction, and the short side extends in the Y-direction. In other words, the longitudinal direction of the cavity 3 coincides with the X-direction in which the first region 301 and the second region 302 are arranged.

This allows the first region 301 to have a sufficient dimension in the X-direction for placement of the optical element 11 that is elongated in the direction of the optical axis (X-direction). The increased dimension of the first region 301 in the X-direction makes it easy to increase the length of the sub-mount 12 in the X-direction and to increase the length of each of the internal connection pads D3 and D4 in the X-direction.

It is therefore easy to increase the number of bonding wires W1 and W2 that can be arranged side by side.

According to Embodiment 1, the dimension of the first region 301 in the X-direction is made larger than the dimension of the second region 302 in the X-direction. This helps to ensure a sufficient dimension in the X-axis direction for placement of the optical element 11 and also makes it easy to increase the length of the sub-mount 12 in the X-direction and to increase the length of each of the internal connection pads D3 and D4 in the X-direction. It is therefore easy to increase the number of bonding wires W1 and W2 that can be arranged side by side.

Implementing the above-mentioned configuration together with forming the cavity 3 as a rectangle elongated in the X-direction as described above makes it easier to increase the number of bonding wires W1 and W2 that can be arranged side by side.

As viewed in the Z-direction, the external terminals D1 and D2 are located at a position on the insulating base 2A where the external terminals D1 and D2 at least partially overlap the metal base 2B.

This helps to ensure that heat conducted to the external terminals D1 and D2 and further to the vias V1 and V2 respectively located under the external terminals D1 and D2 is readily conducted in the Z-direction and absorbed by the metal base 2B.

This helps to reduce conduction of heat generated in the optical element 11 toward the reflecting component 8, which consequently reduces potential deformation of the reflecting component 8 caused by heat. This leads to stable optical characteristics.

According to Embodiment 1, the external terminals D1 and D2 are located in the Y-direction passing through the first mounting portion 4 and perpendicular to the X-direction in which the first region 301 and the second region 302 are arranged.

This helps to reduce an increase in the overall size of the package in the X-direction, which allows for miniaturization of the package.

### (Embodiment 2)

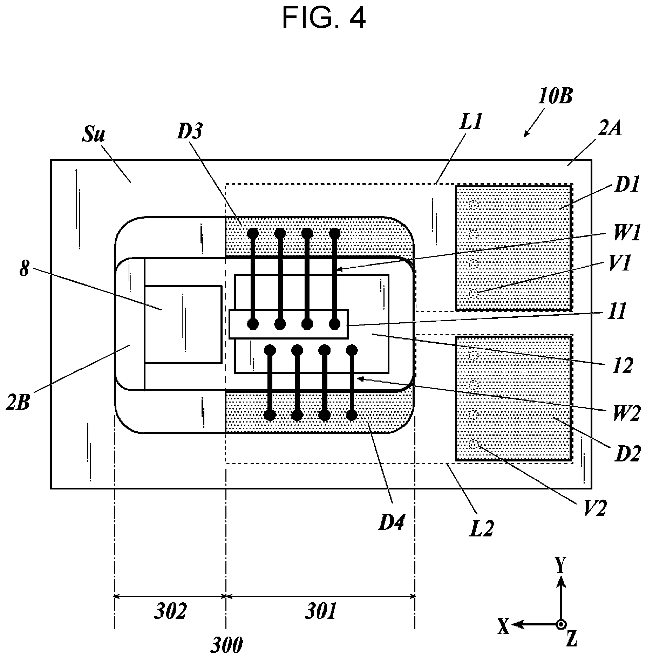

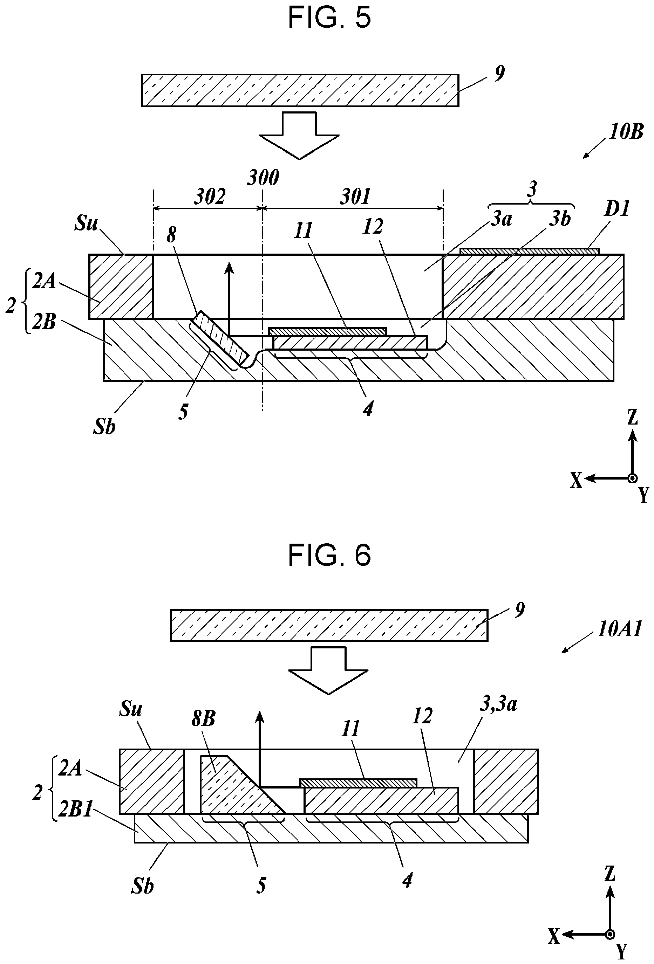

Embodiment 2 representing a modification of Embodiment 1 mentioned above is illustrated in each of Figs. 4 and 5.

According to Embodiment 1 mentioned above, the external terminals D1 and D2 are located in the Y-direction passing through the first mounting portion 4 and perpendicular to the X-direction in which the first region 301 and the second region 302 are arranged.

As opposed to Embodiment 1, for an optical-element mounting package according to Embodiment 2 and an electronic device 10B using the optical-element mounting package according to Embodiment 2, the external terminals D1 and D2 are located on the opposite side across the first mounting portion 4 from the second mounting portion 5.

The above-mentioned configuration results in increased length of the wiring conductor layers L1 and L2.

Heat that is generated in the optical element 11 and to be conducted through the wiring conductor layers L1 and L2 is conducted away in the X-direction from the second region 302 where the reflecting component 8 is located.

This helps to reduce conduction of heat generated in the optical element 11 toward the reflecting component 8, which consequently reduces potential deformation of the reflecting component 8 caused by heat. This leads to stable optical characteristics.

In comparison to Embodiment 1 mentioned above, Embodiment 2 results in increased dimension in the X-direction but allows for reduced dimension in the Y-direction.

### (Embodiment 3)

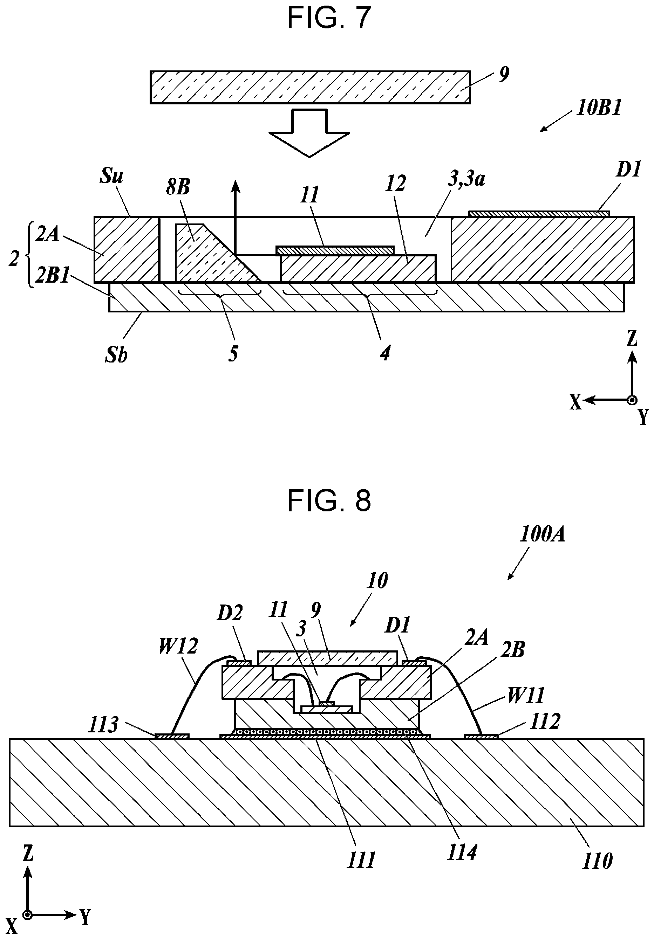

Embodiment 3 representing a modification of Embodiment 1 or 2 mentioned above is illustrated in each of Figs. 6 and 7.

According to Embodiments 1 and 2 mentioned above, the reflecting component 8 is a flat mirror. Alternatively, as with an optical-element mounting package illustrated in each of Figs. 6 and 7 and electronic devices 10A1 (Fig. 6) and 10B1 (Fig. 7) that use the optical-element mounting package illustrated in each of Figs. 6 and 7, a prism 8B may be used.

According to Embodiments 1 and 2 mentioned above, the metal base 2B is provided with the recess 3b. In this regard, as with the optical-element mounting package illustrated in each of Figs. 6 and 7 and the electronic devices 10A1 (Fig. 6) and 10B1 (Fig. 7) that use the optical-element mounting package illustrated in each of Figs. 6 and 7, an alternative configuration may be employed as described below. According to this configuration, a flat-shaped metal base 2B1 is used, and the internal space of the cavity 3 is defined only by the through-hole 3a of the insulating base 2A.

Using the prism 8B in combination with the flat-shaped metal base 2B1 helps to ensure that even if the second mounting portion 5 on which the prism 8B is to be mounted is an X-Y plane, the reflecting surface of the prism 8B that reflects incoming light from the optical element 11 can be easily inclined with respect to the X-Y plane.

### <Electronic Module>

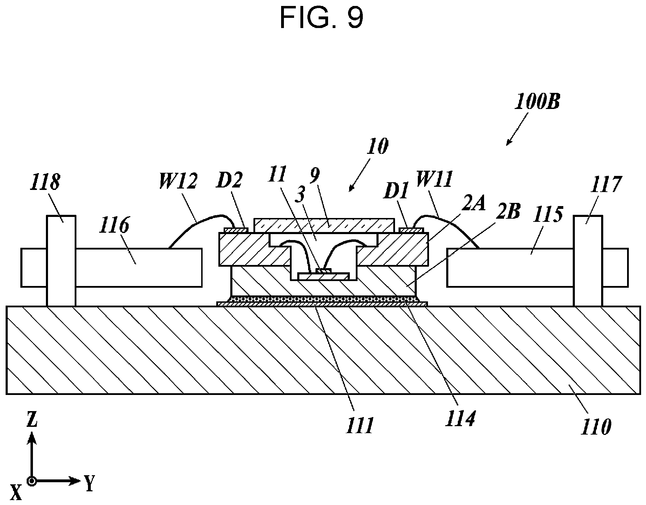

Fig. 8 is a longitudinal sectional view of an exemplary electronic module. Fig. 9 is a longitudinal sectional view of another exemplary electronic module.

An electronic module 100A in Fig. 8 includes the electronic device 10 mounted over a module substrate 110. Alternatively, the electronic device 10B, 10A1, or 10B1 according to each of the modifications mentioned above may be mounted. In addition to the electronic device 10, other components such as another electronic device, an electronic element, and an electrical element may be mounted over the module substrate 110. The module substrate 110 is provided with electrode pads 111, 112, and 113. The electronic device 10 is joined to the electrode pad 111 via a joining material 114 such as solder. More specifically, the lower surface (second surface Sb) of the metal base 2B is joined to the electrode pad 111 via the joining material 114 such as solder. The external terminals D1 and D2 of the electronic device 10 may be respectively connected to the electrode pads 112 and 113 of the module substrate 110 via bonding wires W11 and W12. A signal may be output from the module substrate 110 to the electronic device 10 via the electrode pads 112 and 113 of the module substrate 110 and via the bonding wires W11 and W12.

In an electronic module 100B illustrated in Fig. 9, the external terminals D1 and D2 of the electronic device 10 are respectively connected to lead pins 115 and 116 of the module substrate 110 via the bonding wires W11 and W12. The lead pins 115 and 116 are electrode terminals respectively supported to the module substrate 110 by lead-pin supports 117 and 118. A signal may be output from the module substrate 110 to the electronic device 10 via the lead pins 115 and 116 of the module substrate 110 and via the bonding wires W11 and W12.

As described above, with the electronic module 100A or 100B according to this embodiment, light having required beam characteristics can be emitted by the electronic device 10 (10B, 10A1, 10B1) within a small component space.

Embodiments of the present disclosure have been described above. These embodiments, however, are not intended to limit the present invention. For example, the details illustrated in the embodiments and the drawings, such as the materials, shapes, and sizes of various portions of the bases or optical components may be modified or altered as appropriate without departing from the scope and spirit of the invention.

### Industrial Applicability

The present disclosure can find utility as an optical-element mounting package, an electronic device, and an electronic module.

### Reference Signs List

2 base
2A insulating base
2B metal base
3 cavity
3a through-hole
3b recess
4 first mounting portion
5 second mounting portion
8 reflecting component
9 lid
10 electronic device
11 optical element
12 sub-mount
100A, 100B electronic module
110 module substrate
111, 112, 113 electrode pad
114 joining material
115, 116 lead pin
117, 118 lead-pin support
D1, D2 external terminal
D3, D4 internal connection pad
L1, L2 wiring conductor layer
V1, V2 via
W1, W2 bonding wire
W11, W12 bonding wire
301 first region
302 second region

## Claims

1. An optical-element mounting package comprising:
a metal base;
an insulating base having a frame shape and located on the metal base;
an external terminal located on the insulating base;
a wiring located in the insulating base and electrically connected to the external terminal; and
a reflecting component,
wherein a cavity enclosed by the metal base and an inner wall of the insulating base includes a first region and a second region,
wherein the first region includes a first mounting portion for an optical element,
wherein the second region includes a second mounting portion for the reflecting component,
wherein the first region and the second region are arranged in a direction in which light from the optical element travels toward the reflecting component, and
wherein the wiring is located toward the first region relative to the second region.

2. The optical-element mounting package according to Claim 1, wherein in plan view, the wiring is located in a direction perpendicular to a direction of arrangement of the first region and the second region and passing through the first mounting portion.

3. The optical-element mounting package according to Claim 1 or 2, wherein the external terminal is located at a position where the external terminal at least partially overlaps the metal base.

4. The optical-element mounting package according to any one of Claims 1 to 3, wherein a longitudinal direction of the cavity coincides with a direction of arrangement of the first region and the second region.

5. The optical-element mounting package according to any one of Claims 1 to 4, wherein in plan view, the external terminal is located in a direction perpendicular to a direction of arrangement of the first region and the second region and passing through the first mounting portion.

6. The optical-element mounting package according to any one of Claims 1 to 5, wherein the external terminal is located on an opposite side across the first mounting portion from the second mounting portion.

7. The optical-element mounting package according to any one of Claims 1 to 6, wherein the cavity includes a recess defined in the metal base.

8. The optical-element mounting package according to any one of Claims 1 to 7, wherein the wiring is positioned to extend continuously through an interior of the insulating base into the cavity from an outer surface of the insulating base on which the external terminal is to be disposed.

9. An electronic device comprising:
the optical-element mounting package according to any one of Claims 1 to 8; and
an optical element mounted over the first mounting portion.

10. An electronic module comprising:
the electronic device according to Claim 9; and
a module substrate over which the electronic device is mounted.
